**Europäisches Patentamt**

**European Patent Office**

**Office européen des brevets**

(11) Veröffentlichungsnummer: **0 122 313**
**B1**

(12) # EUROPÄISCHE PATENTSCHRIFT

(45) Veröffentlichungstag der Patentschrift:
07.01.87

(51) Int. Cl.⁴: **H 01 L 21/00**, H 01 L 21/82,
H 01 L 29/08

(21) Anmeldenummer: **83103719.7**

(22) Anmeldetag: **18.04.83**

(54) Verfahren zum Herstellen einer monolithisch integrierten Schaltung mit mindestens einem integrierten Isolierschicht-Feldeffekttransistor.

(43) Veröffentlichungstag der Anmeldung:
24.10.84 Patentblatt 84/43

(45) Bekanntmachung des Hinweises auf die Patenterteilung:
07.01.87 Patentblatt 87/2

(84) Benannte Vertragsstaaten:
DE FR GB IT NL

(56) Entgegenhaltungen:
FR - A - 2 358 748
GB - A - 2 056 167
US - A - 4 005 450
US - A - 4 235 011

(73) Patentinhaber: **Deutsche ITT Industries GmbH,
Hans-Bunte-Strasse 19 Postfach 840, D-7800 Freiburg
(DE)**

(84) Benannte Vertragsstaaten: **DE**

(73) Patentinhaber: **ITT INDUSTRIES INC., 320 Park Avenue,
New York, NY 10022 (US)**

(84) Benannte Vertragsstaaten: **FR GB IT NL**

(72) Erfinder: **Blossfeld, Lothar, Dipl.-Phys., Waldstrasse 23,
D-7800 Freiburg-Hochdorf (DE)**

(74) Vertreter: **Morstadt, Volker, Dipl.-Ing., c/o Deutsche ITT
Industries GmbH Patent/Lizenzabteilung
Postfach 840 Hans-Bunte-Strasse 19,
D-7800 Freiburg/Brsg. (DE)**

### Beschreibung

Aus der DE-A-1 564 411 ist ein Isolierschicht-Feldeffekttransistor bekannt, dessen Drainzone des ersten Leitungstyps in einer Oberfläche eines halbleitenden Substrats des zweiten Leitungstyps eingesetzt ist und die von einer schwächer als die eigentliche Drainzone dotierte Teilzone des zweiten Leitungstyps umgeben ist. Der Zweck der Teilzone ist die Erzielung einer verhältnismässig niedrigen Ausgangskapazität gleichzeitig mit einer niedrigen Änderungsgeschwindigkeit der Verarmungsbreite im Substratgebiet.

Die Erfindung geht nun von der Erkenntnis aus, dass ein solcher Feldeffekttransistor eine erhöhte Durchbruchsspannung aufweist.

Aufgabe der Erfindung ist die Angabe eines Verfahrens, das die Herstellung einer monolithisch integrierten Schaltung mit mindestens einem solchen Isolierschicht-Feldeffekttransistor mit erhöter Drain- und/oder Source-Durchbruchspannung gestattet.

Die Erfindung betrifft ein Verfahren zum Herstellen einer monolithisch integrierten Schaltung mit mindestens einem integrierten Isolierschicht-Feldeffekttransistor, dessen Drainzone und dessen Sourcezone des zweiten Leitungstyps in eine Oberfläche eines halbleitenden Substrats des ersten Leitungstyps eingesetzt sind, wobei mindestens eine der Zonen von einer Teilzone des zweiten Leitungstyps umgeben ist, welche schwächer dotiert ist als diese Zonen.

Die oben genannte Aufgabe wird erfindungsgemäss durch die im kennzeichnenden Teil des Anspruchs 1 angegebenen Verfahrensmassnahmen gelöst.

Ein weiterer Vorteil eines solchen Verfahrens besteht darin, dass in Weiterbildung des Gedankens nach der Erfindung dieses Verfahren ohne weiteres kompatibel mit einem Verfahren ist, welches die Herstellung einer monolithisch integrierten Schaltung mit planaren Bipolartransistoren gestattet, wie es aus der veröffentlichten Europäischen Patentanmeldung EP-A-0 071 665 bekannt ist. Bei diesem bekannten Verfahren wird nach der Herstellung der Kollektorzonen ein aus selektiv ätzbaren Teilschichten bestehender Oxidationsmaskierungsschichtteil auf dem Emitterbereich erzeugt und als selektiv wirksame Implantationsmaske bei den Implantationen der Dotierungen der einen dünneren Basiszonenteil und einen dickeren äusseren Basiszonenteil aufweisenden Basiszone verwendet.

Bei einer in Richtung dieses bekannten Verfahrens entwickelten Weiterbildung des Verfahrens nach der Erfindung wird ebenfalls eine aus selektiv ätzbaren Teilschichten bestehende Oxidationsmaskierungsschicht aufgebracht, deren Teilschichten insgesamt oder auch zumindest die zuunterst liegende Verwendung als Gateisolatorschicht des hochsperrenden Isolierschicht-Feldeffekttransistors findet bzw. finden, also hinsichtlich ihrer Dickenbemessungen entsprechend dimensioniert sind. Auf diese Weise kann stets ein Teil der Schichtenstruktur ermittelt werden, welche nicht nur entsprechend der Erfindung als Oxidationsmaskierungsschicht und zumindest teilweise als Gateisolatorschicht dienen kann, sondern auch noch als Ionenmaskierungsschicht bei der Herstellung der einen dünneren inneren Basiszonenteil und einen dickeren äusseren Basiszonenteil aufweisenden Basiszonen von Bipolartransistoren Verwendung findet. Die Diffusion der Drain-Teilzone und/oder der Source-Teilzone kann ohne weiteres mit der Kollektorzonendiffusion und die Diffusion der eigentlichen niederohmigen Drainzone und/oder Sourcezone in einfacher Weise mit der Emitterzonendiffusion kombiniert werden.

Ein hervorragender Vorteil des Verfahrens der Erfindung besteht also darin, dass dieses mit dem bekannten Verfahren der oben genannten Europäischen Patentanmeldung EP-A-0 071 665 mit dem geringsten Mehraufwand an Arbeitsgängen kombinierbar ist.

Das im folgenden anhand der Figuren der Zeichnung beschriebene Ausführungsbeispiel dient daher zugleich auch zur Beschreibung dieser Kombination der Herstellung einer monolithisch integrierten Schaltung mit einem hochsperrenden Isolierschicht-Feldeffekttransistor, dessen Sourcezone als auch Drainzone von je einer Teilzone umgeben ist und mit einem planaren Bipolartransistor. Die angegebenen Leitungstypen werden den auch möglichen Leitungstypen entgegengesetzten Vorzeichens vorgezogen.

Die Figuren der Zeichnung, welche zur Erläuterung der aufeinanderfolgenden Herstellungsstadien eines Verfahrens nach der Erfindung dienen, zeigen ausschnittsweise eine monolithische Festkörperschaltung in üblicher Darstellung mit Schrägschnittansichten zur Substratoberfläche. Nach dem Verfahren der Erfindung können monolithisch integrierte Festkörperschaltungen mit nahezu jeder beliebigen Anzahl von Feldeffekttransistoren als auch Bipolartransistoren hergestellt werden.

Während der Teil A der Figuren die Herstellung eines integrierten Bipolartransistors betrifft, wird im Teil B der Figuren die Herstellung eines hochsperrenden Isolierschicht-Feldeffekttransistors nach der Erfindung erläutert. Da nach dem Verfahren der Erfindung auch integrierte MOS-Schaltungen ohne Bipolartransistoren herstellbar sind, wird zunächst das Verfahren der Erfindung anhand des Teils B der Figuren geschildert.

Es wird von einem p-leitenden Substrat 1 aus Silizium ausgegangen, auf dem mittels einer ersten Photomaske M1 eine erste Ionenmaskierungsschicht 81 gebildet wird. Zu diesem Zwecke kann das Substrat oxidiert werden und aus der entstandenen Oxidschicht mittels der ersten Photomaske M1 eine Ionenmaskierungsschicht aus Siliziumoxid gebildet werden. Beim Ausführungsbeispiel wird jedoch unmittelbar die Photomaske M1 als Ionenmaskierungsschicht 81 verwendet.

Obwohl es in vielen Anwendungen sicherlich ausreichend ist, allein den Drain-PN-Übergang hochsperrend auszubilden, ist es zweckmässig, auch den Source-PN-Übergang hochsperrend zu erhalten. Aus diesem Grunde werden beim Ausführungsbeispiel sowohl die Sourcezone als auch die Drainzone von je einer hochohmigen Teilzone umgeben. Es werden demgemäss beide Teilzonenbereiche 32 und 42 der herzustellenden Teilzonen 31 und 41 freigelegt und

in diese Bereiche der Substratoberfläche Ionen vom zweiten Leitungstyp, also vom N-Leitungstyp, mit einer Dosis entsprechend der Dotierung der Teilzonen 31 und 41 implantiert. Die Ionenmaskierungsschicht 81 wird danach entfernt.

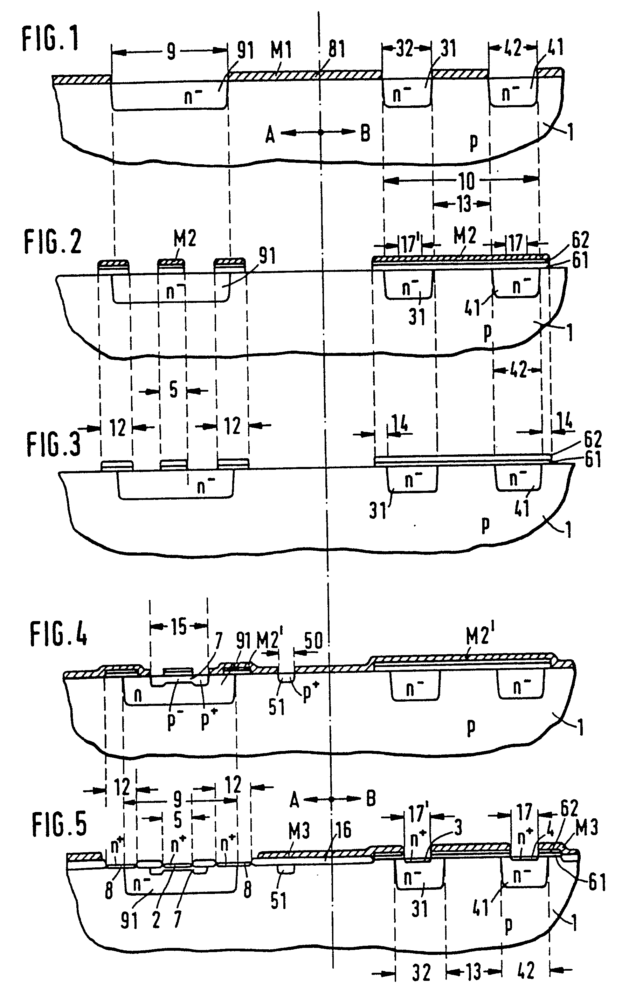

Zur Ausbildung der Zonen 31, 41 und Aktivierung der Dotierungen wird nun das Substrat getempert und auf der gesamten Substratoberfläche eine Oxidationsmaskierungsschicht 61, 62 erzeugt, auf die eine Photolackschicht aufgebracht wird. Diese wird in bekannter Weise durch eine photographische Maske belichtet, so dass entsprechend der üblichen photolithographischen Technik die zweite Photomaske M2 erzeugt wird, welche den gesamten Bereich 10 des Feldeffekttransistors einschliesslich der PN-Übergangsbereiche 14 bedeckt, wie die Fig.2 veranschaulicht. Die Breite der PN-Übergangsbereiche 14 ist entsprechend der beabsichtigten Drain-Substratabbruchspannung zu bemessen. Nach Anwendung eines zweistufigen Plasmaätzprozesses, bei dem die Photomaske M1 als Ätzmaske wirkt, wird die Struktur gemäss der Fig. 2 erhalten.

Die Oxidationsmaskierungsschicht 61, 62 besteht zumindest aus einer unteren Teilschicht 61 und einer oberen Teilschicht 62, so dass die selektive Ätzbarkeit der Schichten zur Erfüllung der sonst schwierig aneinander anzupassenden Bedingungen des Verfahrens nach der Erfindung, insbesondere im Hinblick auf die Dicke der Gateisolatorschicht, erfüllt werden kann. Vorzugsweise wird eine untere Teilschicht 61 aus Siliziumdioxid und eine obere Teilschicht 62 aus Siliziumnitrid aufgebracht. Wird beispielsweise die untere Teilschicht als Gate-Isolatorschicht verwendet, so ist diese hinsichtlich ihrer Dicke entsprechend dem gewünschten Schwellwert anzupassen, der noch in einem späteren Stadium mittels einer Ionenimplantation durch die Gateisolatorschicht modifizierbar ist.

Da die Fig. 4 die erwähnte Weiterbildung des Verfahrens nach der Erfindung im Hinblick auf die Herstellung eines Bipolartransistors betrifft und Arbeitsgänge erläutert, welche nicht zur Herstellung des Isolierschichtfeldeffekttransistors erforderlich sind, kann diese Fig. 4 zunächst übergangen werden.

Jedenfalls wird bei dem Verfahren nach der Erfindung nach Aufbringen der Oxidationsmaskierungsschicht 61 und 62, wie es anhand der Fig. 3 beschrieben wurde, in einem späteren Stadium die freie Substratoberfläche unter Bildung der Oxidschicht 16 gemäss der Fig. 5 oxidiert und eine dritte Photomaske M3 als Ätzmaske aufgebracht. Diese Photomaske M3 weist innerhalb der Teilzonenbereiche 32 und 42 Öffnungen entsprechend den Zonenbereichen 17, 17' auf, welche innerhalb der Teilzonenbereiche 32 und 42 liegen. Die Abstände der Ränder der Zonenbereiche 17 bzw. 17' von den Rändern der Teilzonenbereiche 32 bzw. 42 sind so gross zu wählen, dass die Raumladungszonen der PN-Übergänge sich ungehindert zu den noch herzustellenden Zonen 3, 4 ausdehen können.

In die bereits dotierten Teilzonenbereiche 31 und 41 werden nun unter Verwendung der dritten Photomaske M3 als Implantationsmaske Dotierungen mit einer ausreichend grossen Dosis in Form von Ionen vom zweiten Leitungstyp implantiert. Es ergibt sich eine Anordnung gemäss dem Bereich B in der Fig. 5.

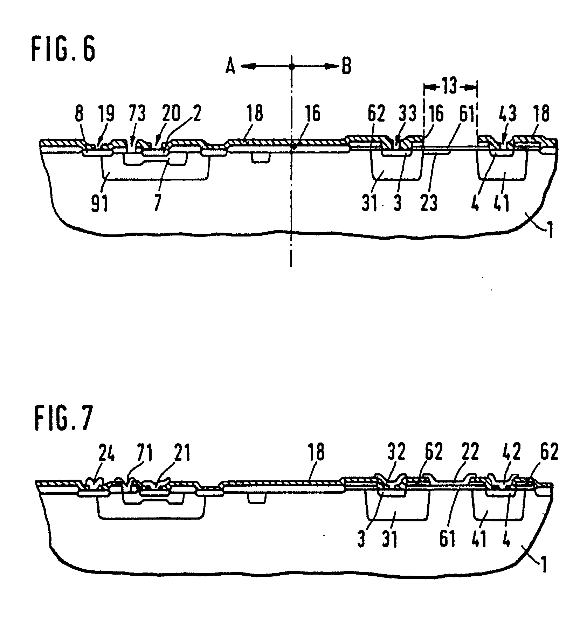

Es wird nach Entfernung der dritten Photomaske M3 anschliessend die Oberfläche der Anordnung einschliesslich der Oxidschicht 16 und der Oxidationsmaskierungsschicht 61, 62 mit der Oxidschicht 18 bedeckt und nach Temperung der Anordnung zur Aktivierung der Dotierungen eine vierte Photomaske aufgebracht, welche Öffnungen zu den Zonen 3, 4 in Abständen zu deren Rändern entsprechend der oben erwähnten Bemessungsregel und zu dem Teil der stehengebliebenen Oxidationsmaskierungsschicht oberhalb des Gatebereichs 13 aufweist, wie die Fig. 6 veranschaulicht. Im übrigen ist zur Vereinfachung der Darstellung in der Fig. 6 die vierte Photomaske weggelassen worden, deren Struktur sich natürlich mit der Struktur der als Kontaktierungsmaske dienenden Fremdoxidschicht 18 deckt.

Nach Ausätzen der Öffnungen 16, 33 und 43 wird, falls nur die Teilschicht 61 als Gateisolator verwendet werden soll, die obere aus Siliziumnitrid bestehende Teilschicht 62 selektiv durch Plasmaätzung entfernt, so dass unter Verwendung der vierten Photomaske zusammen mit der Fremdoxidschicht 18 als Ätzmaske die Gateoxidschicht freigelegt wird. Diese war bisher in vorteilhafter Weise durch die darüberliegende Nitridschicht geschützt worden. Die Öffnung 13 muss bekannterweise die Zonen 31, 41 überlappen.

Unter Verwendung einer weiteren Photolackmaske als Implantationsmaske können nun durch die Gateoxidschicht Ionen zur Einstellung der Schwellwertspannung des Feldeffekttransistors implantiert werden. Es ist vorteilhaft, eine solche Implantation unter Verwendung einer besonderen Implantationsmaske auf dem Bereich 23 des Gatebereichs 13 angrenzend an die Teilzone 31 der Sourcezone 3 zu beschränken. Schliesslich werden unter Verwendung einer fünften Photomaske in bekannter Weise aus einer auf die Oberfläche der Anordnung aufgebrachten Leitschicht die Elektroden 32, 42 an den Zonen 3 bzw. 4 und die Gateelektrode 22 herausgeätzt.

Als Gateisolatorschicht kann natürlich auch die gesamte Oxidationsmaskierungsschicht im Gatebereich 13 oder auch irgend eine Anzahl von selektiv ätzbaren Teilschichten verwendet werden.

In einer besonderen Weiterbildung des Verfahrens nach der Erfindung werden zunächst auf dem Substrat 1 mittels einer ersten Photomaske M1 eine erste Ionenmaskierungsschicht 81 gebildet, welche ausser mindestens einem der Teilzonenbereiche 31 und 41 den im Teil A der Figuren dargestellten Kollektorzonenbereich 9 eines planaren Bipolartransistors unbedeckt lässt, wie die Fig. 1 veranschaulicht. Danach erfolgt die Implantation von Ionen des zweiten Leitungstyps in die unbedeckten Teile der Substratoberfläche, eine Entfernung der Ionenmaskierungsschicht 81 und die Temperung des Substrats gemäss dem bereits beschriebenen Ausführungsbeispiel.

Anschliessend wird wiederum eine zweite Photomaske M2 hergestellt, mit deren Hilfe eine Oxidationsmaskierungsschicht 61, 62 erzeugt wird, welche ausser dem gesamten Bereich 13 des Feldeffekttransistors einschliesslich des PN-Übergangsbereichs 14 den Emitterbereich 5 und den Kollektorkon-

taktierungsbereich 12 des Bipolartransistors mit einer Oxidationsmaskierungsschicht 61, 62 abdeckt.

Die Dicke dieser Oxidationsmaskierungsschicht ist in besonderer Weise zu bemessen, wie aus der eingangs erwähnten Europäischen Patentanmeldung 0 071 665 bekannt ist. Danach ist die Dicke der Oxidationsmaskierungsschicht derart zu bemessen, dass bei einem ersten von zwei in beliebiger Reihenfolge erfolgenden Implantationsprozessen die Beschleunigungsspannung, dass die Ionenmaskierungsschicht von den Ionen durchdrungen wird, und die Beschleunigungsspannung bei dem zweiten Ionenimplantationsprozess auf solche relativ kleine Werte begrenzt ist, bei denen die Ionen maskiert werden. Bei dem ersten Ionenimplantationsprozess, der mit niedriger Dosis, beispielsweise zwischen $2 \cdot 10^{12} cm^{-2}$ bis $5 \cdot 10^{13} cm^{-2}$ erfolgt, werden Ionen sowohl in den inneren als auch in den äusseren Basisbereich implantiert, während bei dem Ionenimplantationsprozess relativ niedriger Beschleunigungsenergie, beispielsweise kleiner als 100 KeV, lediglich der äussere Basisbereich dotiert wird.

Die beiden Implantationsprozesse erfolgen dann nach Entfernung der zweiten Photomaske M2 und Maskierung des gesamten Bereiches 13 des Isolierschichtfeldeffekttransistors und eines PN-Übergangsbereichs 14 bzw. beider Übergangsbereiche 14 und 14' mittels einer als Implantationsmaske verwendbaren und den Basisbereich 15 des Bipolartransistors freilassenden Photolackmaske M2', wie die Fig. 4 veranschaulicht. Zur Verdeutlichung der Wirkung der beiden Ionenimplantationsprozesse ist in der Fig.4 die Basiszone 7 bereits abgestuft dargestellt, obwohl erst später bei einem Hochtemperaturprozess nach Aktivierung der implantierten Dotierungen die Basiszone in der dargestellten Form ausgebildet wird. Die Fig. 4 lässt weiter eine besondere Ausbildung der Photolackmaske M2' erkennen, nämlich die Öffnung 50, welche zur Herstellung der Kanalunterbrecherzone 51 unter Verwendung der erwähnten beiden Implantationsprozesse dient.

Danach wird die als Implantationsmaske verwendbare Photolackmaske M2' sorgfältig entfernt und anschliessend die freiliegende Substratoberfläche unter Bildung der Oxidschicht 16 oxidiert, welche sich über alle die Teile der Substratoberfläche erstreckt, welche nicht mittels der Oxidationsmaskierungsschicht 61, 62 geschützt sind.

Anschliessend wird die dritte Photolackmaske M3 aufgebracht. Diese weist, wie die Fig. 5 veranschaulicht, ausser den Öffnungen zur Freilegung der Substratoberfläche innerhalb der Zonenbereiche 17 und 17' bzw. des Zonenbereichs 17 eine Öffnung auf, welche zumindest den Kollektorbereich 9 und den Kollektorkontaktierungsbereich 12 unbedeckt lässt. Bei der anschliessenden Verwendung der dritten Photolackmaske M3 als Ätzmaske werden daher ausser den freigelegten Teilen der Oxidationsmaskierungsschicht 61, 62 in den Zonenbereichen 17, 17' bzw. in den Zonenbereich 17 diese Schicht auch im Emitterbereich 5 und im Kollektorkontaktierungsbereich 12 entfernt.

In die freigelegten Bereiche der Substratoberfläche werden dann Ionen vom zweiten Leitungstyp implantiert, so dass nach einer entsprechenden Temperung die Emitterzone 2, die vorzugsweise rahmenförmig ausgebildete Kollektorkontaktierungszone 8 ausser den Zonen 3 und 4 entstehen, wie die Fig. 5 veranschaulicht. Natürlich erfolgt vor der Temperung die Entfernung der dritten Photolackmaske M3.

Die gesamte Oberfläche der Anordnung wird nun mit der Oxidschicht 18 bedeckt, auf der nach der Temperung eine vierte Photolackmaske aufgebracht wird, welche die Öffnungen 19, 20, 73, 33 und 43 zu den Zonen 2, 3, 4, 7 und 8 in Abständen zu deren Rändern aufweist. Diese vierte Photomaske enthält ausserdem eine Öffnung zu dem Gatebereich 13. Anschliessend können in den Gatebereich 13 unter Verwendung einer besonderen Implantationsmaske zur Einstellung des Kennliniencharakters Dotierungen in den Gatebereich durch die Gateisolatorschicht implantiert werden. Es ist günstig, angrenzend an die Source-Teilzone 31 und damit überlappend einen höher als der Gatebereich 13 dotierten Dotierungsbereich 23 zu implantieren, der sich zur Drain-Teilzone 41 etwa über die Hälfte hin erstreckt. Dieser Dotierungsbereich 23 kann natürlich auch bereits nach der Ablösung der in Fig. 1 dargestellten ersten Ionenmaskierungsschicht 81 unter Verwendung einer besonderen Ionenmaskierungsschicht implantiert werden.

Nach der Entfernung der Fremdoxidschicht 18 innerhalb der Öffnungen der vierten Photolackmaske wird in üblicher Weise eine Leitschicht und darüber eine fünfte Photolackmaske aufgebracht, welche derartig strukturiert ist, dass aus der aufgebrachten Leitschicht die erforderlichen Elektroden 32, 42, 22, 21, 24 und 71 gemäss der Fig. 7 herausgeätzt werden können.

## Patentansprüche

1. Verfahren zum Herstellen einer monolithisch integrierten Schaltung mit mindestens einem integrierten Isolierschicht-Feldeffekttransistor, dessen Drainzone (4) und dessen Sourcezone (3) des zweiten Leitungstyps in eine Oberfläche eines halbleitenden Substrats (1) des ersten Leitungstyps eingesetzt sind, wobei mindestens eine der Zonen (3, 4) von einer Teilzone (31; 41) des zweiten Leitungstyps umgeben ist, welche schwächer dotiert ist als diese Zonen, dadurch gekennzeichnet,

- dass zunächst auf dem Substrat (1) mittels einer ersten Photolackmaske (M1) eine erste Ionenmaskierungsschicht (81), gebildet wird, welche mindestens einen der Teilzonenbereiche (32; 42) der herzustellenden Teilzonen (31; 41) bzw. der Teilzone unbedeckt lässt,

- dass dann in die unbedeckten Teile der Substratoberfläche Ionen vom zweiten Leitungstyp mit einer Dosis entsprechend der Dotierung der Teilzonen (31; 41) implantiert werden und danach die Ionenmaskierungsschicht (81) entfernt wird,

- dass anschliessend das Substrat getempert wird und unter Verwendung einer zweiten Photolackmaske (M2) eine Oxidationsmaskierungsschicht (61, 62) erzeugt wird, welche den gesamten Bereich (10) des Feldeffekttransistors einschliesslich der PN-Übergangsbereiche (14) der hergestellten Teilzonen (31; 41) bzw. Teilzone bedeckt, welche Oxidationsmaskierungsschicht (61, 62) zumindest eine an die Substratoberfläche angrenzende untere Teilschicht (61) und eine obere Teilschicht (62) enthält, welche untereinander selektiv ätzbar sind und wovon zumindest die untere Teilschicht als Gate-Isolatorschicht verwendbar ist (Fig. 2),
- dass danach die freie Substratoberfläche unter Bildung einer Oxidschicht (16) oxidiert wird und unter Verwendung einer dritten Photolackmaske (M3) als Ätzmaske ein erster Zonenbereich (17) innerhalb des ersten Teilzonenbereichs (42) und/oder ein zweiter Zonenbereich (17') innerhalb des zweiten Teilzonenbereichs (32) der Substratoberfläche freigelegt wird und unter Verwendung der dritten Photolackmaske (M3) als Implantationsmaske in die bereits implantierten Bereiche Ionen vom zweiten Leitungstyp mit einer Dosis entsprechend der Dotierung der Zonen (3, 4) implantiert werden (Fig. 5),
- dass anschliessend die Oberfläche der Anordnung einschliesslich der Oxidschicht (16) und der Oxidmaskierungsschicht (61, 62) mit einer Oxidschicht (18) bedeckt wird, auf der nach Temperung der Anordnung zur Aktivierung der Dotierungen eine vierte Photolackmaske aufgebracht wird, welche Öffnungen (16, 33, 43) zu den Zonen (3, 4) in Abständen zu deren Rändern und zu dem Teil der Oxidationsmaskierungsschicht (61, 62) oberhalb des Gatebereichs (13) aufweist (Fig. 6),
- dass danach die Fremdoxidschicht (18) innerhalb der Öffnungen der vierten Photolackmaske selektiv bis auf die obere Teilschicht (62) oder bis auf die untere Teilschicht (61) und innerhalb des Zonenbereichs (17) bzw. der Zonenbereiche (17; 17') bis auf die Zonen (3, 4) zur Bildung von Kontaktöffnungen durch Ätzen entfernt wird und
- dass schliesslich unter Verwendung einer fünften Photolackmaske aus einer auf die Oberfläche der Anordnung aufgebrachten Leitschicht Elektroden (18, 32, 22) und Leiterbahnen herausgeätzt werden.

2. Verfahren nach Anspruch 1, dadurch gekennzeichnet,
- dass zunächst auf dem Substrat (1) mittels einer ersten Photolackmaske (M1) eine erste Ionenmaskierungsschicht (81) gebildet wird, welche ausser mindestens einem der Teilzonenbereiche (10; 11) den Kollektorzonenbereich (9) eines planaren Bipolartransistors unbedeckt lässt (Fig. 1),
- dass nach der Implantation von Ionen des zweiten Leitungstyps in die unbedeckten Teile der Substratoberfläche, der Entfernung der Ionenmaskierungsschicht (81) und der Temperung des Substrats anschliessend unter Verwendung einer zweiten Photolackmaske (M2) eine Oxidationsmaskierungsschicht (61, 62) erzeugt wird, welche ausser dem gesamten Bereich (13) einschliesslich eines PN-Übergangsbereichs (41), den Emitterbereich (5) und den Kollektorkontaktierungsbereich (12) mit einer Oxidationsmaskierungsschicht (61, 62) solcher Dicke deckt, dass diese Schicht (61, 62) bei einem ersten Implantationsprozess mit geringer Dosis und relativ hoher Beschleunigungsspannung von Dotierungsionen des Leitungstyps der Basiszone (7) durchlässig ist und bei einem zweiten Implantationsprozess mit relativ geringer Beschleunigungsspannung von Ionen des gleichen Leitungstyps maskiert (Fig.2),
- dass danach die zweite Photolackmaske (M2) entfernt wird (Fig. 3),
- dass dann der gesamte Bereich (13) des Isolierschicht-Feldeffekttransistors und ein PN-Übergangsbereich (14) bzw. beide Übergangsbereiche (14, 14') mittels einer als Implantationsmaske verwendbaren und den Basisbereich (15) freilassenden Photolackmaske (M2') maskiert werden und die beiden Implantationsprozesse in beliebiger Reihenfolge durchgeführt werden (Fig. 4),
- dass danach die als Implantationsmaske verwendbare Photolackmaske (M2') entfernt und dann die freiliegende Substratoberfläche unter Bildung der Oxidschicht (16) oxidiert wird,
- dass anschliessend die dritte Photolackmaske (M3) aufgebracht wird, welche ausser den Öffnungen zur Freilegung der Substratoberfläche innerhalb der Zonenbereiche (17, 17') bzw. des Zonenbereichs (17) eine Öffnung aufweist, welche zumindest den Kollektorbereich (9) und den Kollektorkontaktierungsbereich (12) unbedeckt lässt, so dass bei der anschliessenden Verwendung der dritten Photolackmaske (M3) als Ätzmaske ausser den freigelegten Teilen der Oxidationsmaskierungsschicht (61, 62) in den Zonenbereichen (17, 17') bzw. in dem Zonenbereich (17) die Schicht (61, 62) auch im Emitterbereich (5) und im Kollektorkontaktierungsbereich (12) entfernt wird,
- dass dann Ionen vom zweiten Leitungstyp implantiert werden (Fig. 5),
- dass anschliessend nach Entfernung der dritten Photolackmaske (M3) die Oberfläche der Anordnung mit der Fremdoxidschicht (18) bedeckt wird, auf der nach der Temperung eine vierte Photolackmaske aufgebracht wird, welche Öffnungen (19, 20, 73, 33, 43) zu den Zonen (2, 3, 4, 7, 8) in Abständen zu deren Rändern abgesehen von der Öffnung zu dem Gatebereich (13) aufweist (Fig. 6) und
- dass nach Entfernung der Oxidschicht innerhalb der Öffnungen der vierten Photolackmaske die fünfte Photolackmaske aufgebracht wird, unter deren Verwendung aus der aufgebrachten Leitschicht die Elektroden (32, 42, 22, 21, 24, 71) und die Leiterbahnen herausgeätzt werden (Fig. 7).

3. Verfahren nach Anspruch 1 oder 2, dadurch gekennzeichnet, dass eine Oxidationsmaskierungsschicht (61, 62) erzeugt wird, welche aus einer unteren Teilschicht (61) aus Siliziumdioxid und einer oberen Teilschicht (62) aus Siliziumnitrid besteht.

**Claims**

1. Method of producing a monolithic integrated circuit comprising at least one integratet insulated-gate field-effect transistor whose drain zone (4) and whose source zone (3) of the second conductivity type are introduced into one surface of a semiconducting substrate (1) of a first conductivity type, with at least one of the zones (3, 4) being surrounded by a partial zone (31; 41) of the second conductivity type which is doped weaker than these zones, characterized in

- that first of all on the substrate (1), with the aid of a first photoresist mask (M1) there is formed a first ion masking layer (81) which leaves at least one of the partial zone areas (32; 42) of the partial zones (31; 41) or the partial zone to be manufactured, uncovered,
- that then, into the non-covered portions of the substrate surface, ions of the second conductivity type in a dose corresponding to the doping of the partial zones (31; 41) are implanted, and that the ion masking layer (81) is removed thereafter,
- that after this the substrate is tempered and, by employing a second photoresist mask (M2) there is produced an oxidation masking layer (61, 62) which covers the entire area (10) of the field-effect transistor including the pn junction areas (14) of the produced partial zones (31; 41) or partial zone only, with this oxidation masking layer (61, 62) at least containing a lower partial layer (61) adjoining the substrate surface and an upper partial layer (62), and which, among each other, are selectively etchable, and of which at least the lower partial layer is capable of being used as a gate insulating layer (Fig. 2),
- that after this the free (exposed) substrate surface is oxidized by forming an oxide layer (16) and, by using a third photoresist mask (M3) serving as an etching mask, there is exposed a first zone area (17) within the first partial zone area (42) and/or a second zone area (17') within the second partial zone area (32) of the substrate surface and that, by employing the third photoresist mask (M3) for serving as an implantation mask, ions of the second conductivity type and in a dose corresponding to the doping of the zones (3, 4) are implanted into the already impanted areas (Fig. 5),
- that after this the surface of the arrangement including the oxide layer (16) and the oxide masking layer (61, 62), is covered with an oxide layer (18) on which, following the tempering of the arrangement for activating the dopings, there is deposited a fourth photoresist mask comprising openings (16, 33, 34) extending to the zones (3, 4) at certain distances in relation to the rim portions thereof, and to the portion of the oxidation masking layer (61, 62) lying above the gate areas (13) (Fig. 6),
- that after this the foreign-oxide layer (18), within the openings of the fourth photoresist mask, is removed by way of etching selectively down to the upper partial layer (62) or down to the lower partial layer (61) and, within the zone area (17) or the zone areas (17; 17') down to the zones (3, 4) for the purpose of forming contact openings, and
- that finally, by employing a fifth photoresist mask, electrodes (18, 32, 22) and conductor leads are etched out of a conductive layer as deposited onto the surface of the arrangement.

2. A method as claimed in claim 1, characterized in

- that first of all, on the substrate (1) and with the aid of a first photoresist mask (M1) there is formed a first ion masking layer (81) which, apart from at least one of the partial zone areas (10; 11), leaves free the collector zone area (9) of a planar bipolar transistor (Fig. 1),
- that after the implantation of ions of the second conductivity type into the non-covered portions of the substrate surface, after removal of the ion masking layer (81) and after the tempering of the substrate, and by using a second photoresist mask (M2) there is produced an oxidation masking layer (61, 62) which, apart from the entire area (13) including a pn junction area (41), covers the emitter area (5) and the collector contacting area (12) with an oxidation masking layer (61, 62) of such thickness that this layer (61, 62), in the course of a first implantation process, with a small dose and a relatively high accelerating voltage of doping ions of the conductivity type of the base zone (7), is transmissive and, in the course of a second implantation process a relatively low accelerating voltage of ions of the same conductivity type, effects a masking (Fig. 2),
- that thereafter the second photoresist mask (M2) is removed (Fig. 3),
- that then the entire area (13) of the insulated-gate field-effect transistor and one pn junction area (14) or both junction areas (14, 14') are masked with the aid of a photoresist mask (M2') which is capable of being used as an implantation mask and leaves free the base area (15), with both implantation processes being carried out in an optional order of succession (Fig. 4),
- that after this the photoresist mask (M2') which is cabable of being used as an implantation mask, is removed and that the exposed substrate surface is oxidized by forming an oxide layer (16),
- that thereafter the third photoresist mask (M3) is applied which, apart from the openings for exposing the substrate surface within the zone areas (17, 17') or one zone area (17) comprises an opening which leaves uncovered at least the collector area (9) and the collector contacting area (12), so that during the subsequently following use of the third photoresist mask (M3) as an etching mask, apart from the exposed portions of the oxidation masking layer (61, 62) in the zone areas (17, 17') or in the zone area (17), the layer (61, 62) is also removed within both the emitter area (5) and the collector contacting area (12),
- that after this ions of the second conductivity type are implanted (Fig. 5),
- that following the removal of the third photoresist mask (M3) the surface of the arrangement is covered with a foreign-oxide layer (18) on which, after the tempering, there is deposited a fourth photoresist mask comprising apart from the opening extending to the gate area (13) (Fig. 6), openings (19, 20, 73, 33, 43) extending to the zones (2, 3, 4, 7, 8) at certain distances from the rim portions thereof, and
- that after the oxide layer has been removed within the openings in the fourth photoresist mask, the fifth photoresist mask is deposited, by the use of which the electrodes (32, 42, 22, 21, 24, 27) and the conductor leads are etched out of the deposited conductive layer (Fig. 7).

3. A method as claimed in claim 1 or 2, characterized in that an oxidation masking layer (61, 62) is produced which consists of a lower partial layer (61) of silicon dioxide and of an upper partial layer (62) of silicon nitride.

## Revendications

1. Procédé de fabrication de circuit intégré monolithique comprenent au moins un transistor à effet de champ à grille isolée dont la zone de drain (4) et la zone de source (3) du second type de conductibilité sont incorporées dans la surface d'un substrat semiconducteur (1) du premier type de conductibilité, l'une de ces zones (3, 4) au moins étant entourée d'une zone partielle (31; 41) du second type de conductibilité dont le dopage est d'un niveau inférieur à celui desdites zones, caractérisé en ce que:
- tout d'abord, une première couche de masquage d'implantation ionique (81) est formée sur tout le substrat (1) en laissant à découvert au moins un emplacement de zone partielle (32; 42) des zones partielles (31; 41) ou de la zone partielle à produire, grâce à l'emploi d'un premier masque en résine photosensible (M1),
- puis, dans les parties à découvert de la surface du substrat, des ions du second type de conductibilité sont implantés avec un dosage correspondant au dopage des zones partielles (31; 41), après quoi la couche de masquage d'implantation ionique (81) est enlevée,
- ensuite, le substrat est recuit et, en employant un second masque en résine photosensible (M2) une couche de masquage d'oxydation (61, 62) est produite, recouvrant toute la surface (10) du transistor à effet de champ, y compris les emplacements de jonction PN (14) des zones partielles produites (31; 41) ou de la seule zone partielle, cette couche de masquage d'oxydation (61, 62) contenant au moins une couche partielle inférieure (61) en contact avec la surface du substrat et une couche partielle supérieure (62), ces deux couches, entre autres, pouvant faire l'objet d'une attaque chimique sélective et la couche partielle inférieure au moins pouvant être utilisée comme couche d'isolement de grille (fig. 2),
- puis, la surface découverte du substrat est oxydée pour formée une couche d'oxyde (16) et, en utilisant un troisième masque en résine photosensible (M3) servant de masque d'attaque chimique, un premier emplacement de zone (17) est découvert dans le premier emplacement de zone partielle (42) et/ou un second emplacement de zone (17') est découvert dans le second emplacement de zone partielle (32) jusqu'à la surface du substrat et, en employant le troisième masque en résine photosensible (M3) comme masque d'implantation, des ions du second type de conductibilité sont implantés dans les emplacements déjà implantées (fig. 5), avec un dosage correspondant au dopage desdites zones (3, 4),
- ensuite, la surface du dispositif, y compris la couche d'oxyde (16) et la couche de masquage d'oxydation (61, 62), est recouverte d'une couche d'oxyde (18) sur laquelle, après recuit du dispositif pour activation des dopants, un quatrième masque en résine photosensible est déposé, comprenant des ouvertures (16, 33, 43) qui s'étendent jusqu'auxdites zones (3, 4), à une certaine distance par rapport aux bords de celle-ci, et aux parties de la couche de masquage d'oxydation (61, 62) se situant au-dessus de l'emplacement de grille (13) (fig. 6),
- puis encore, la couche d'oxyde apporté (18), dans les ouvertures du quatrième masque en résine photosensible, est enlevée par attaque chimique sélective jusqu'à la couche partielle supérieure (62) ou la couche partielle inférieure (61) et, dans l'emplacement de zone (17) ou les emplacements de zones (17, 17'), jusqu'aux zones, afin de former les ouvertures des contacts et,
- finalement, en employant un cinquième masque en résine photosensible, des électrodes (18, 32, 22) et des trajets conducteurs sont délimités par attaque chimique dans une couche conductrice déposée à la surface du dispositif.

2. Procédé selon la revendication 1, caractérisé en ce que:
- tout d'abord, une première couche de masquage d'implantation ionique (81) est formée sur le substrat (1) à l'aide d'un premier masque en résine photosensible (M1), laquelle laisse à découvert l'emplacement de zone de collecteur (9) d'un transistor bipolaire, en plus d'au moins un des emplacements des zones partielles (10; 11) (fig. 1),
- puis, après l'implantation d'ions du second type de conductibilité dans les parties découvertes de la surface du substrat, l'enlèvement de la couche de masquage d'implantation ionique (81) et le recuit du substrat, en utilisant un deuxième masque en résine photosensible (M2), une couche de masquage d'oxydation (61, 62) est produite, laquelle, en dehors de l'étendue totale (13) comportant un emplacement de jonction PN (41) recouvre l'emplacement d'émetteur (5) et l'emplacement de contact de collecteur (12) d'une couche de masquage d'oxydation (61, 62) d'une épaisseur telle que cette couche (61, 62) est traversée, au cours d'une première étape d'implantation ionique, avec un dosage faible et une tension d'accélération relativement élevée, par des ions dopants du type de conductibilité de la zone de base (7) et se comporte en masque, au cours d'une seconde étape d'implantation ionique sous une tension d'accélération relativement faible d'ions du même type de conductibilité (fig. 2),
- ensuite, le deuxième masque en résine photosensible (M2) est enlevé (fig. 3),
- puis l'étendue totale (13) du transistor à effet de champ à grille isolée et un emplacement de jonction PN (14) ou des deux emplacements de jonction (14, 14') sont masquées à l'aide d'un masque en résine photosensible (M2') qui peut être utilisé comme masque d'implantation et laisse à découvert l'étendue de base (15), les deux étapes d'implantation étant accomplies dans un ordre de succession quelconque (fig. 4),
- puis encore, le masque en résine photosensible (M2') pouvant être utilisé comme masque d'implantation est enlevé et la surface exposée du substrat est oxydée pour former une couche d'oxyde (16),

- après quoi, le troisième masque en résine photosensible (M3) est appliqué, lesquel, outre les ouvertures pour découvrir la surface du substrat dans les emplacements de zones (17, 17') ou un emplacement de zone (17) comprend une ouverture qui découvre au moins l'emplacement de collecteur (9) et l'emplacement de contact de collecteur (12), de sorte que, durant l'utilisation ultérieure du troisième masque en résine photosensible (M3) comme masque d'attaque chimique, la couche (61, 62) est enlevée, outre dans les parties découvertes de la couche de masquage d'oxydation (61, 62) dans les emplacements de zones (17, 17') ou dans l'emplacement de zone (17), aussi dans l'emplacement d'émetteur (5) et l'emplacement de contact de collecteur (12),

- puis, des ions du second type de conductibilité sont implantés (fig. 5), - et, après enlèvement du troisième masque en résine photosensible (M3) la surface du dispositif est recouverte d'une couche d'oxyde apportée (18) sur laquelle, après recuit, il est déposé un quatrième masque en résine photosensible comprenant, en dehors de l'ouverture s'étendant jusqu'à l'emplacement de grille (13), (fig. 6), des ouvertures (19, 20, 73, 33, 43) s'étendant jusqu'aux zones (2, 3, 4, 7, 8) à une certaine distance du bord de celles-ci et,

- après l'enlèvement de la couche d'oxyde dans les ouvertures du quatrième masque en résine photosensible, le cinquième masque en résine photosensible est déposé, au moyen les électrodes (32, 42, 22, 21, 24, 27) et les conducteurs de liaison sont définis par attaque chimique de la couche conductrice déposée (fig. 7).

3. Procédé selon la revendication 1 ou 2, caractérisé en ce que la couche de masquage d'oxydation (61, 62) produite consiste en une couche partielle inférieure (61) en dioxide de silicium et une couche partielle supérieure (2) en nitrure de silicium.

FIG.1

FIG.2

FIG.3

FIG.4

FIG.5

FIG. 6

A ←——→ B

|← 13 →|

8  19  73  20  2    18    16    62  33  16  61  43  18

91    7         31  3  23    4  41

1

FIG. 7

24  71  21    18    32  62  22  42  62

3  31    61  41  4

1